(19) Europäisches Patentamt
European Patent Office
Office européen des brevets

(11) **EP 1 296 191 B1**

(12) **EUROPÄISCHE PATENTSCHRIFT**

(45) Veröffentlichungstag und Bekanntmachung des Hinweises auf die Patenterteilung:
**07.11.2007 Patentblatt 2007/45**

(51) Int Cl.:
***G03F 7/20*** *(2006.01)*    ***G01M 11/02*** *(2006.01)*

(21) Anmeldenummer: **02019258.9**

(22) Anmeldetag: **28.08.2002**

(54) **Verfahren zur Optimierung der Abbildungseigenschaften mehrerer optischer Elemente**

Method of optimising the imaging properties of a plurality of optical elements

Méthode d'optimisation des caractéristiques de formation d'image de plusieurs éléments optiques

(84) Benannte Vertragsstaaten:
**DE NL**

(30) Priorität: **21.09.2001 DE 10146499**

(43) Veröffentlichungstag der Anmeldung:
**26.03.2003 Patentblatt 2003/13**

(73) Patentinhaber: **CARL ZEISS SEMICONDUCTOR MANUFACTURING TECHNOLOGIES AG**
**73447 Oberkochen (DE)**

(72) Erfinder:
- **Geh, Bernd**
  **73432 Aalen (DE)**
- **Gräupner, Paul**
  **73430 Aalen (DE)**
- **Stammler, Thomas, Dr.**
  **73430 Aalen (DE)**
- **Stenkamp, Dirk, Dr.**
  **73457 Essingen (DE)**
- **Stühler, Jochen**
  **73431 Aalen (DE)**
- **Wurmbrand, Klaus**
  **79460 Hüttlingen (DE)**

(74) Vertreter: **Ostertag, Ulrich et al**
**Patentanwälte**
**Ostertag & Partner**
**Epplestr. 14**
**70597 Stuttgart (DE)**

(56) Entgegenhaltungen:
**EP-A- 0 992 853        EP-A- 1 128 218**

- **PATENT ABSTRACTS OF JAPAN Bd. 2000, Nr. 07, 29. September 2000 (2000-09-29) -& JP 2000 121491 A (NIKON CORP), 28. April 2000 (2000-04-28)**
- **PATENT ABSTRACTS OF JAPAN Bd. 1998, Nr. 11, 30. September 1998 (1998-09-30) -& JP 10 154657 A (NIKON CORP), 9. Juni 1998 (1998-06-09)**
- **FUKUDA HIROSHI ET AL: "Determination of high-order lens aberration using phase/amplitude linear algebra" JOURNAL OF VACUUM SCIENCE & TECHNOLOGY B: MICROELECTRONICS PROCESSING AND PHENOMENA, AMERICAN VACUUM SOCIETY, NEW YORK, NY, US, Bd. 17, Nr. 6, November 1999 (1999-11), Seiten 3318-3321, XP012007927 ISSN: 0734-211X**

**Beschreibung**

Die Erfindung betrifft ein Verfahren zur Optimierung der Abbildungseigenschaften von mindestens zwei optischen Elementen, bei dem mindestens eines der optischen Elemente relativ zu mindestens einem stationären optischen Element bewegt wird.

Optische Baugruppen mit mindestens einem beweglichen optischen Element sind von Markt her bekannt. Hierzu gehören Projektionsobjektive der Mikrolithographie. Bei diesen, aber auch bei anderen optischen Baugruppen, ist eine hohe Abbildungsqualität zur möglichst fehlerfreien Erzeugung des Bildes einer Struktur notwendig. Die Beweglichkeit von mindestens einem optischen Element innerhalb eines solchen Projektionsobjektivs dient der Variation der Abbildungseigenschaften des Projektionsobjektivs mit dem Ziel der Verringerung der auftretenden Abbildungsfehler.

Die Wahl der Position, in die ein bewegliches optisches Element zu bringen ist, damit der Abbildungsfehler der optischen Baugruppe minimiert ist, erfolgt bisher oft durch Einzelmessung der Abbildungseigenschaften der optischen Elemente vor dem Zusammenbau. Da sich manche Abbildungsfehler erst beim Zusammenbau ergeben, z.B. durch Druckeinflüsse der Halterungen für die optischen Elemente, ist ein derartiger Ansatz zur Erreichung einer hohen Abbildungsqualität zu ungenau.

Andere Ansätze, bei denen eine Optimierung der Positionen der optischen Elemente anhand von leicht visualisierbaren, die Abbildungsqualität aber nur unvollkommen wiedergebenden Zielgrößen erfolgt, die aus dem Zusammenwirken der optischen Elemente gewonnen wurden, vertrauen bei der Auffindung der günstigsten Drehposition auf die Erfahrung des mit der Justage der Baugruppe beauftragten Technikers. Derartige Optimierungsverfahren sind zu wenig deterministisch.

Ein notwendig zur optimalen Relativposition zwischen dem beweglichen und dem stationären optischen Element führendes Verfahren nimmt Messungen der Abbildungsfehler der optischen Baugruppen, die das bewegliche und das stationäre optische Element umfaßt, an allen anfahrbaren Positionen des beweglichen optischen Elements vor. Dies ist, da zur genauen Positionierung des beweglichen optischen Elements in der Regel eine Vielzahl anfahrbarer Positionen vorliegt, zu langwierig und aufwendig.

Bei der Suche nach Möglichkeiten zur Verbesserung von Projektionsobjektiven zur Erfüllung immer höherer Anforderungen an die Abbildungsqualität sind Projektionsobjektive vorgestellt worden, bei denen bewegliche optische Komponenten an verschiedenen Positionen innerhalb des Projektionsobjektivs angeordnet werden können. Dabei ist die Anzahl der beweglichen optischen Komponenten nicht auf eine beschränkt, sondern es können oft mehrere optische Elemente innerhalb des Projektionsobjektivs beweglich sein.

Bei derartigen Projektionsobjektiven stellt sich die Frage, an welcher Stelle ein bewegliches optisches Element innerhalb des Projektionsobjektivs vorzusehen ist, um einen bestimmten Abbildungsfehler korrigieren zu können, und wie viele optische Elemente ggf. hierzu bewegt werden müssen. Ferner stellt sich die Frage, welcher Bewegungsfreiheitsgrad zur Korrektur eines bestimmten Abbildungsfehlers einsetzbar ist. Derartige Bewegungsfreiheitsgrade sind die Rotation optischer Elemente innerhalb des Projektionsobjektivs, die Verlagerung optischer Elemente längs der optischen Achse des Projektionsobjektivs (Abstimmung) und senkrecht dazu (Zentrierung) und die Verkippung optischer Elemente innerhalb des Projektionsobjektivs.

Insgesamt ergibt sich eine Vielzahl von Freiheitsgraden, die prinzipiell zur Korrektur von Abbildungsfehlern innerhalb eines Projektionsobjektivs zur Verfügung stehen.

Bei den bisher bekannten optischen Baugruppen erfolgte eine Auswahl der Freiheitsgrade, die zur Korrektur von Abbildungsfehlern herangezogen wurden, auf der Basis von Trial-and-Error-Methoden. Ähnlich wie bei der Auffindung der günstigsten Drehposition war auch hier die Erfahrung des jeweiligen Technikers ausschlaggebend beim Auffinden nutzbarer Freiheitsgrade, was zu nicht deterministisch nachvollziehbaren Justageergebnissen führte. Oft erforderte die Auswahl der zu bewegenden Linsen sowie die Auswahl der Bewegungsfreiheitsgrade sehr viel Zeit und führte auch nicht immer zum Erreichen vorgegebener Spezifikationen.

Auch in den Fällen, in denen prinzipiell bekannt ist, welche Linsen innerhalb eines Projektionsobjektivs zur Korrektur bestimmter Abbildungsfehler bewegt werden müssen, liegt bei einer Beweglichkeit mehrerer Linsen innerhalb eines Projektionsobjektivs in der Regel immer noch ein multidimensionales Problem vor, so daß eine optimale Positionskonfiguration aller beweglichen Linsen, bei der ein Gesamtabbildungsfehler vorgegebene Spezifikationen unterschreitet bzw. ein absolutes Minimum erreicht, mit vertretbarem Aufwand oft nicht gefunden werden kann Aus der EP-A-0 992 853 ist ein Verfahren zur Verbesserung der Abbildungseigenschaften eines Projektionsobjektivs einer mikrolithographischen Projektionsbelichtungsanlage bekannt, bei dem zwei Linsen oder Linsengruppen entlang der optischen Achse zur Korrektor von Abbildungsfehlern verfahren werden können. Zusätzlich besteht die Möglichkeit, die Emissionswellenlänge des als Lichtquelle verwendeten Lasers zur Abbildungskorrektur zu verändern. Bei dem Verfahren wird zunächst gemessen, wie sich bestimmte Abbildungsfehler verändern, wenn jeweils eine der beiden Linsen oder Linsengruppen um einen bestimmten Betrag verfahren wird. Entsprechendes gilt auch für die Emissionswellenlänge. Anschliessend wird die Linse oder die Linsengruppe auf eine gewünschte Position verfahren. Die EP-A-0 992 853 offenbart jedoch nicht die Bestimmung der Abbildungsfehler einer beweglichen Linse oder Linsengruppe separat von den stationären linsengruppen.

Die Gesamtänderung der betreffenden Abbildungsfehler ergibt sich dann durch additive Überlagerung der Einzelbeiträge. Für drei gemessene Abbildungsfehler läßt sich dann durch Lösen eines Gleichungssystems ermitteln, wie die beiden Linsen oder Linsengruppen verfahren und die Wellenlänge verändert werden muß, um eine möglichst gute Korrektur zu erhalten.

Es ist daher eine erste Aufgabe der vorliegenden Erfindung, ein Verfahren zur Optimierung der Abbildungseigenschaften von mindestens zwei optischen Elementen, bei dem mindestens eines der optischen Elemente relativ zu mindestens einem stationären optischen Element bewegt wird, anzugeben, mit dem der Gesamtabbildungsfehler der mindestens zwei optischen Elemente mit vergleichsweise geringem Aufwand gezielt reduziert werden kann.

Diese Aufgabe wird erfindungsgemäß gelöst durch ein Verfahren mit folgenden Verfahrensschritten:

a) Messen des sich aus dem Abbildungsfehler des beweglichen optischen Elements und dem Abbildungsfehler des stationären optischen Elements zusammensetzenden Gesamtabbildungsfehlers aller optischen Elemente, wobei alle optischen Elemente von Meßlicht durchtreten werden;

b) Darstellen des gemessenen Gesamtabbildungsfehlers als Linearkombination der Basisfunktionen eines orthogonalen Funktionensatzes;

c) Bewegen des beweglichen optischen Elements relativ zum stationären optischen Element in eine neue Meßposition;

d) erneutes Messen des sich aus dem Abbildungsfehler des beweglichen Elements und dem Abbildungsfehler des stationären optischen Elements zusammensetzenden neuen Gesamtabbildungsfehlers aller optischen Elemente, wobei alle optischen Elemente von Meßlicht durchtreten werden;

e) Darstellen des neuen Gesamtabbildungsfehlers als Linearkombination der Basisfunktionen eines orthogonalen Funktionensatzes;

f) Berechnen des Abbildungsfehlers des beweglichen optischen Elements und des Abbildungsfehlers des stationären optischen Elements unter Verwendung der in den Schritten b und e gewonnenen Darstellungen;

g) Berechnen einer Zielposition des beweglichen optischen Elements aus dessen Abbildungsfehler und dem Abbildungsfehler des stationären optischen Elements, in welcher der Gesamtabbildungsfehler minimiert ist;

h) Bewegen des beweglichen optischen Elements in die Zielposition.

Das erfindungsgemäße Verfahren ermittelt zunächst in situ die Abbildungsfehlerbeiträge des beweglichen und des stationären optischen Elements. Dabei wird die Tatsache ausgenutzt, daß bei Darstellung des Gesamtabbildungsfehlers als Linearkombination der Basisfunktionen eines orthogonalen Funktionensatzes sich der Gesamtabbildungsfehler des beweglichen und des stationären optischen Elements sowohl vor als auch nach der Bewegung des beweglichen optischen Elements wohldefiniert aus den Einzelbeiträgen der Abbildungsfehler des beweglichen und des stationären optischen Elements zusammensetzt. Daher kann aus zwei Messungen des Gesamtabbildungsfehlers, nämlich vor und nach einer Bewegung des beweglichen optischen Elements auf die gesonderten Abbildungsfehler des beweglichen und des stationären optischen Elements rückgeschlossen werden. Die so ermittelten gesonderten Abbildungsfehler können dann zur Berechnung einer Zielposition herangezogen werden, d. h. einer Stellung des beweglichen optischen Elements gegenüber dem stationären optischen Element, in der der Gesamtabbildungsfehler der optischen Elemente minimiert ist.

Mit diesem Verfahren wird die Positionskonfiguration mit dem geringsten Gesamtabbildungsfehler bzw. mit einem unterhalb einer Spezifikation liegenden Gesamtabbildungsfehler deterministisch erreicht, wobei keine extern bestimmten Abbildungsgrößen, sondern ausschließlich in situ gemessene Größen verwendet werden. Das Verfahren läßt sich daher automatisieren. Da das Verfahren im Prinzip mit zwei Meßschritten auskommt, läßt es sich relativ rasch durchführen und könnte prinzipiell auch dazu eingesetzt werden, wechselnden Abbildungseigenschaften der optischen Elemente Rechnung zu tragen. In diesem Fall würde das Verfahren von Zeit zu Zeit wiederholt. optischen Elements zusammensetzenden Gesamtabbildungsfehlers aller optischen Elemente, wobei alle optischen Elemente von Meßlicht durchtreten werden;

b) Darstellen des gemessenen Gesamtabbildungsfehlers als Linearkombination der Basisfunktionen eines orthogonalen Funktionensatzes;

c) Bewegen eines oder mehrerer der beweglichen optischen Elemente gemeinsam in eine neue Meßposition;

d) Erneutes Messen des Gesamtabbildungsfehlers der optischen Elemente, der sich aus dem Abbildungsfehler des einen bewegten Elements oder der gemeinsam bewegten optischen Elemente und dem Abbildungsfehler der restlichen optischen Elemente zusammensetzt, wobei alle optischen Elemente von Meßlicht durchtreten werden;

e) Darstellen des neuen Gesamtabbildungsfehlers als Linearkombination der Basisfunktionen eines orthogonalen Funktionensatzes;

f) Berechnen der Abbildungsfehler des einen bewegten optischen Elements oder der gemeinsam bewegten optischen Elemente und des Abbildungsfehlers der restlichen optischen Elemente unter Verwendung der in den Schritten b und e gewonnenen Darstellungen;

g) Wiederholen der Verfahrensschritte c bis f für ein anderes oder mehrere andere der optischen Elemente, bis jedes bewegliche optische Element mindestens einmal relativ zu dem oder den ihm nächst benachbarten optischen Elementen bewegt wurde;

h) Berechnen einer Zielposition der beweglichen optischen Elemente aus den Abbildungsfehlern der einzelnen beweglichen optischen Elemente und dem mindestens einen stationären optischen Element, in welcher der Gesamtabbildungsfehler minimiert ist;

i) Bewegen der beweglichen optischen Elemente in die berechnete Zielposition.

Bei diesem Verfahren ist das Grundprinzip des ersten erfindungsgemäßen Verfahrens dahingehend fortgeführt, daß zunächst die gesonderten Abbildungsfehler aller gegeneinander beweglichen optischen Elemente bestimmt werden. Anschließend wird auf der Basis der berechneten gesonderten Abbildungsfehler der gegeneinander beweglichen optischen Elemente eine Zielposition der beweglichen optischen Elemente bestimmt, in welcher der Gesamtabbildungsfehler minimiert ist. Da aufgrund der Darstellung der Abbildungsfehler als Linearkombination der Basisfunktionen eines orthogonalen Funktionensatzes die Änderung des Gesamtabbildungsfehlers als Folge der Bewegung der beweglichen optischen Elemente berechnet werden kann, ist es nicht erforderlich, zur Optimierung des Projektionsobjektivs alle möglichen Relativpositionen der beweglichen Elemente tatsächlich anzufahren. Es genügt, jedes bewegliche optische Element mindestens einmal relativ zu den ihm benachbarten optischen Elementen zu bewegen.
Dies reduziert die Anzahl der erforderlichen Bewegungsschritte und damit den Aufwand zur Ermittlung einer Positionskonfiguration mit optimierten Abbildungseigenschaften erheblich. Nach der Bestimmung der einzelnen Abbildungsfehler ist das Bestimmen der Zielposition eine deterministische Rechenaufgabe, so daß nur noch die Zielposition eingestellt zu werden braucht.
Beim Berechnen der Zielposition können fiktiv, also nicht durch reale Relativbewegung sondern durch Rechnung, entweder alle Positionskombinationen der gegeneinander beweglichen optischen Elemente untersucht werden und dabei das globale Minimum des Gesamtabbildungsfehlers ermittelt werden. Alternativ kann ein statistisches Verfahren herangezogen werden, bei dem stichprobenartig bestimmte Positionskombinationen getestet werden und auf diese Weise eine Annäherung an das globale Minimum möglich wird, ohne daß dazu jede mögliche Positionskombination durchgerechnet zu werden braucht. Ein hierzu brauchbares statistisches Verfahren kann durch die Übertragung eines Problems aus der statistischen Mechanik, nämlich dem Auffinden des Zustands eines physikalischen Vielteilchensystems im thermischen Gleichgewicht, gewonnen werden.
Dies reduziert den Rechenaufwand bei der Berechnung der Zielposition erheblich.
Die zuletzt erwähnte Aufgabe wird gelöst durch ein zweites, nicht erfindungsgemäßes Verfahren mit folgenden Verfahrensschritten:

a) Unterteilen der mindestens drei optischen Elemente in einen ersten zu bewegenden Teil und einen zweiten stationären Teil;

b) Messen des Gesamtabbildungsfehlers aller optischen Elemente in einer Ausgangsposition, wobei alle optischen Elemente von Meßlicht durchtreten werden;

c) Darstellen des gemessenen Abbildungsfehlers als Linearkombination der Basisfunktionen eines orthogonalen Funktionensatzes;

d) Bewegen des zu bewegenden Teils der optischen Elemente in eine neue Meßposition;

e) Erneutes Messen des neuen Gesamtabbildungsfehlers aller optischen Elemente in der neuen Meßposition, wobei die optischen Elemente von Meßlicht durchtreten werden;

f) Darstellen des neuen Gesamtabbildungsfehlers als Linearkombination der Basisfunktionen eines orthogonalen Funktionensatzes;

g) Berechnen des Abbildungsfehlers des bewegten Teils der optischen Elemente und des Abbildungsfehlers des stationären Teils der optischen Elemente unter Verwendung der in den Schritten c und f gewonnenen Darstellung;

h) Berechnen einer Zielposition des bewegten Teils oder der bisher bewegten Teile der optischen Elemente, bei der ein Gesamtabbildungsfehler minimiert ist, aus den berechneten Abbildungsfehlern des bewegten und des stationären Teils der optischen Elemente;

i) Vergleichen des ermittelten Gesamtabbildungsfehlers in der berechneten Zielposition mit einem Vorgabewert;

j) falls der Gesamtabbildungsfehler größer ist als der Vorgabewert und noch mindestens ein schon bezüglich des Abbildungsfehlers nach den Schritten a bis g vermessener Teil der optischen Elemente mit mindestens zwei relativ zueinander beweglichen optischen Elementen existiert:

ja) Ermitteln desjenigen schon bezüglich des Abbildungsfehlers nach den Schritten a bis g vermessenen Teils der optischen Elemente, der noch aus mindestens zwei relativ zueinander beweglichen optischen Elementen besteht und den größten Abbildungsfehler aufweist;

jb) Unterteilen des ermittelten Teils der optischen Elemente in einen nächsten zu bewegenden Teil der optischen Elemente und in einen nächsten stationären Teil;

jc) Wiederholen der Verfahrensschritte d bis i für den nächsten zu bewegenden Teil;

jd) Falls kein gemäß Schritt jb unterteilbarer Teil mehr existiert, Ausgabe des Gesamtabbildungsfehlers und Beenden des Justageverfahrens;

k) falls der Gesamtabbildungsfehler kleiner ist als der Vorgabewert, Bewegen des bewegten Teils oder der bisher bewegten Teile in die im Schritt h berechnete Zielposition, falls nicht schon im Rahmen von Schritt i geschehen.

Bei diesem Verfahren ist gewährleistet, daß eine Unterteilung in bewegliche und stationäre Teile des optischen Elements nur so lange erfolgt, bis eine vorgegebene Spezifikation des Gesamtabbildungsfehlers erreicht wird. In der Praxis können zunächst diejenigen Teile als beweglich vorgegeben werden, die erfahrungsgemäß den größten Abbildungsfehlerbeitrag liefern. Erst wenn eine Korrektur des Gesamtabbildungsfehlers durch die Bewegung dieser Teile nicht den gewünschten Erfolg bringt, werden dann automatisch neue Unterteilungen vorgenommen. Dies reduziert den Aufwand beim Bestimmen der optimierten Positionskonfiguration erheblich.

Zum Berechnen der Zielposition können alternativ wieder alle Positionskombinationen der bisher bewegten Teile untersucht und das globale Minimum gesucht werden oder es kann ein statistisches Verfahren, wie oben erwähnt, zum Einsatz kommen.

Das Ermitteln des neuen Gesamtabbildungsfehlers vor dem Vergleich mit dem Vorgabewert im Verfahrensschritt i kann folgende Schritte umfassen:

a) Bewegen des bewegten Teils der optischen Elemente in die berechnete Zielposition;

b) Messen des neuen Gesamtabbildungsfehlers aller optischen Elemente in der Zielposition.

Bei dieser Ausgestaltung wird die berechnete Zielposition durch tatsächliches, also nicht nur fiktives, Bewegen der optischen Elemente in die Zielposition hinsichtlich des Gesamtabbildungsfehlers kontrolliert. Bei Abweichungen zwischen dem berechneten und dem gemessenen Gesamtabbildungsfehler in der Zielposition kann ggf. nochmals eine Bestimmung der Abbildungsfehler der einzelnen bisher bewegten optischen Elemente durchgeführt werden.

Alternativ kann der Gesamtabbildungsfehler vor dem Vergleich mit dem Vorgabewert im Verfahrensschritt i ermittelt werden durch:

Berechnen des neuen Gesamtabbildungsfehlers aller optischen Elemente in der Zielposition aus den berechneten Abbildungsfehlern des bewegten und des stationären Teils der optischen Elemente.

Das mindestens eine bewegliche optische Element kann um die optische Achse verdrehbar sein. Durch Verdrehung optischer Elemente lassen sich nicht rotationssymmetrische Bildfehler von gegeneinander beweglichen optischen Elementen gegenseitig kompensieren. Prinzipiell lassen sich die erfindungsgemäßen Verfahren auch zur Korrektur von Abbildungseigenschaften mittels anderer Bewegungsfreiheitsgrade der beweglichen optischen Elemente einsetzen.

Zur Messung des Gesamtabbildungsfehlers können Luftbilddaten herangezogen werden. Derartige, auf einer Intensitätsmessung im Bereich der Bildebene der optischen Elemente oder einer hierzu konjugierten Ebene beruhende Daten können relativ einfach erhoben werden.

Eine genaue Beschreibung des Gesamtabbildungsfehlers ist dann möglich, wenn zur Messung des Gesamtabbildungsfehlers die Wellenfrontdaten eines Abbildungsbündels nach dem Projektionsobjektiv gemessen werden. Eine derartige genaue Beschreibung des Gesamtabbildungsfehlers gewährleistet eine eindeutige Zuordnung einzelner Fehlerbeiträge, die in vielen Fällen die Voraussetzung für eine Minimierung des Gesamtabbildungsfehlers im Rahmen des Optimierungsverfahrens darstellt.

Die Luftbilddaten können bei verschiedenen Beleuchtungssettings gemessen werden. Luftbildmessungen sind mit relativ geringem Aufwand durchführbar, liefern in der Regel jedoch nur in Bezug auf die azimutale Variation des Gesamtabbildungsfehlers eine eindeutige Information. Wird ein über eine Luftbildmessung erhobener Gesamtabbildungsfehler mittels einer Linearkombination von orthogonalen Funktionen angepaßt, ergibt sich das Problem, daß sich die radialen Variationen des Gesamtabbildungsfehlers nicht eindeutig anpassen lassen, da hierfür die Genauigkeit der Luftbildmessungen im Regelfall nicht ausreicht. Werden Luftbilddaten bei verschiedenen Beleuchtungssettings erhoben, lassen sich auch über Luftbildmessungen Wellenfrontdaten gewinnen, die zur Zuordnung einzelner Fehlerbeiträge ausreichend genau sind. Damit kann auf die Durchführung aufwendigerer Meßverfahren, insbesondere interferometrischer Messungen, zur Bestimmung der Wellenfrontdaten verzichtet werden.

Als orthogonaler Funktionensatz können Zernikefunktionen gewählt werden. Zernikefunktionen werden standardmäßig zur Beschreibung typischer Abbildungsfehler, z. B. der Seidelschen Aberrationen, herangezogen. Den Zernikekoeffizienten kann oftmals direkt ein bestimmter Abbildungsfehler zugeordnet werden, weswegen eine Zerlegung nach Zernikefunktionen einen direkt lesbaren Aussagegehalt hinsichtlich der Abbildungseigenschaften optischer Elemente liefert. Natürlich sind die erfindungsgemäßen Verfahren auch durch Zerlegung in andere orthogonale Funktionensätze wie z.B. Legendre-Polynome durchführbar.

Ausführungsbeispiele der Erfindung werden nachfolgend anhand der Zeichnung näher erläutert; es zeigen:

Figur 1    schematisch eine Projektionsbelichtungsanlage der Mikrolithographie mit einem erfindungsgemäß optimierbaren Projektionsobjektiv in Seitenansicht;

Figur 2    ein Ablaufschema zur Optimierung des Projektionsobjektivs von Figur 1;

Figur 3    in Seitenansicht vier schematisch dargestellte Relativpositionen von optischen Elementen eines alternativen Projektionsobjektivs;

Figur 4    ein Ablaufschema zur Optimierung des Projektionsobjektivs von Figur 3;

Figur 5    eine alternative Projektionsbelichtungsanlage;

Figur 6    schematisch ein alternatives, erfindungsgemäß optimierbares Projektionsobjektiv in Seitenansicht und

Figur 7    ein alternatives Ablaufschema zur Optimierung des Projektionsobjektivs von Fig. 6.

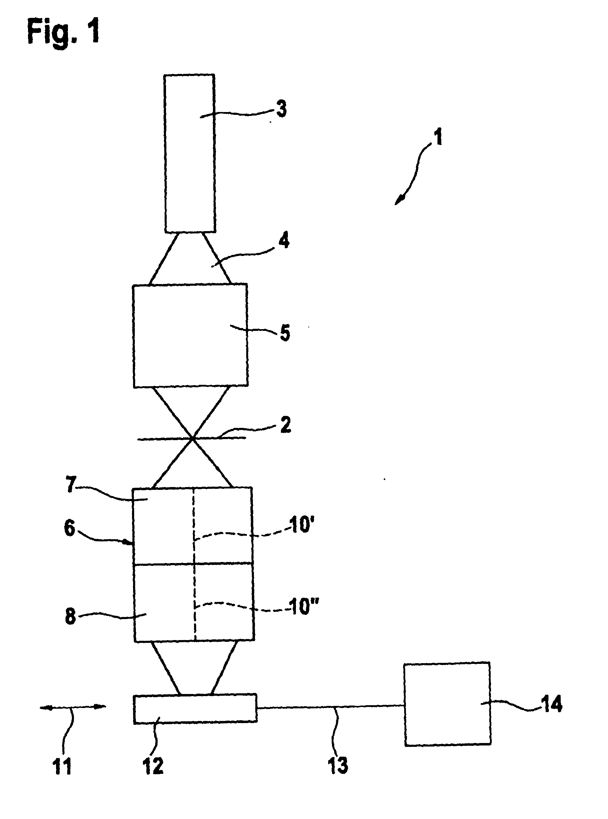

Eine in Figur 1 schematisch dargestellte und insgesamt mit dem Bezugszeichen 1 bezeichnete Projektionsbelichtungsanlage dient zur Übertragung von auf einer Maske 2 befindlichen Strukturen auf einen Wafer (nicht dargestellt).

Die Projektionsbelichtungsanlage 1 weist als Lichtquelle einen UV-Laser 3, z. B. einen ArF-Laser oder einen $F_2$-Laser, auf. Vom Laser 3 emittiertes Projektionslicht 4 durchtritt eine Beleuchtungsoptik 5 und beleuchtet die Maske 2. Die so beleuchteten Strukturen auf der Maske 2 werden von einem Projektionsobjektiv 6 auf den Wafer abgebildet.

Das Projektionsobjektiv 6 weist zwei relativ zueinander bewegliche optische Elemente 7, 8 auf. Die Relativbewegung erfolgt dabei durch Verdrehung des in Figur 1 oberen optischen Elements 7 um die optische Achse des Projektionsobjektivs 6. Die in Figur 1 schematisch dargestellten optischen Elemente 7, 8 können Gruppen von optischen Komponenten, z. B. von Linsen, oder auch einzelne optische Komponenten umfassen.

In der Zeichnung sind die relativ zueinander verdrehbaren optischen Elemente, z. B. die optischen Elemente 7, 8 des Projektionsobjektivs 6 in Figur 1, mit einer parallel zur optischen Achse verlaufenden gestrichelten Umfangsmarkierung 10 versehen, die eine momentane Drehposition des jeweiligen optischen Elements verdeutlicht.

Die Verdrehung des optischen Elements 7 erfolgt durch Lösen der Befestigung des optischen Elements 7 innerhalb des Projektionsobjektivs 6 und manuelles Verdrehen. Anschließend wird das optische Element 7 wieder im Projektionsobjektiv 6 befestigt.

In der schematischen Darstellung der Figur 1 steht das optische Element 8 für alle optischen Elemente, die zum Abbildungsfehler des Projektionsobjektivs 6 beitragen und stationär sind, also bei einer Verdrehung des optischen Elements 7 nicht bewegt werden.

Im Bereich der Bildebene des Projektionsobjektivs 6 ist senkrecht zur optischen Achse von diesem verschiebbar (vgl. Doppelpfeil 11) eine Luftbildmeßeinrichtung 12 vorgesehen. Dieser mißt die Intensität des Projektionslichts 4 im Bereich der Bildebene des Projektionsobjektivs 6. Die Intensitätsmessung kann, wie in Fig. 1 angedeutet, direkt im Bereich der Bildebene oder über eine Zwischenabbildung der Bildebene erfolgen.

Über eine Datenleitung 13 steht die Luftbildmeßeinrichtung 12 mit einem Rechner 14 in Verbindung. Die Luftbildmeßeinrichtung 12 und der Rechner 14 bilden gemeinsam eine Optimierungseinrichtung zur Optimierung der Abbildungseigenschaften des Projektionsobjektivs 6. Diese kann fester Bestandteil der Projektionsbelichtungsanlage 1 sein. Alternativ ist es möglich, daß die gesamte Optimierungseinrichtung oder Teile hiervon bedarfsweise mit dem Projektionsobjektiv verbunden werden, während des Projektionsbetriebs der Projektionsbelichtungsanlage 1 aber von dieser getrennt sind.

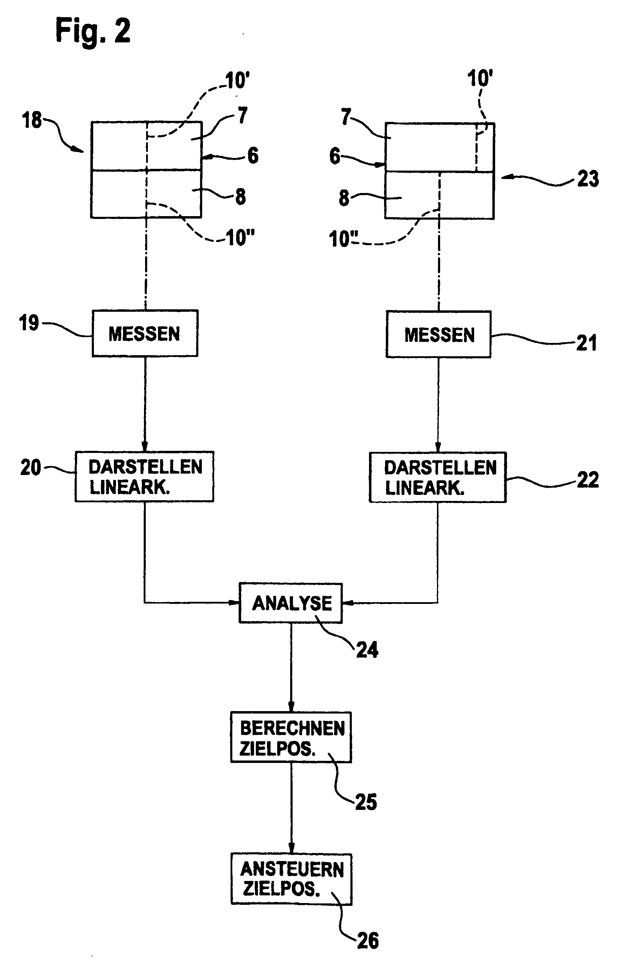

Ein Verfahren zur Optimierung der Abbildungseigenschaften des Projektionsobjektivs 6 wird nachfolgend anhand des Ablaufschemas von Figur 2 beschrieben.

Ausgehend von einer ersten Stellung des Projektionsobjektivs 6, bei der wie in Figur 1 die Umfangsmarkierungen 10 der optischen Elemente 7, 8 miteinander fluchten und die nachfolgend als Ausgangsposition 18 bezeichnet wird, wird in einem Meßschritt 19 mit Hilfe der Luftbildmeßeinrichtung 12 die Wellenfront des Projektionslichts 4 gemessen. Diese ist ein direktes Maß für den Gesamtabbildungsfehler des Projektionsobjektivs 6, der sich aus den Abbildungsfehlern der optischen Elemente 7, 8 zusammensetzt.

Die von der Luftbildmeßeinrichtung 12 aufgenommenen Meßdaten werden über die Datenleitung 13 an den Rechner 14 übermittelt (vgl. Fig. 1).

In einem anschließenden Berechnungsschritt 20 wird der gemessene Gesamtabbildungsfehler als Linearkombination der Basisfunktionen eines orthogonalen Funktionensatzes dargestellt. Als orthogonaler Funktionensatz dienen die Skalar- und Vektor-Zernike-Funktionen Z in Abhängigkeit von den Feldkoordinaten in der Ebene, in der die Messung durch die Luftbildmeßeinrichtung 12 erfolgt.

Beispielhaft wird nachfolgend die Zerlegung des skalaren Bildfehleranteils V des Gesamtabbildungsfehlers in Skalar-Zernike-Funktionen angegeben:

$$V(r, \Phi) = \sum_{n=1}^{i} b^{(i)} Z^{(i)}(r, \Phi)$$

Hierbei sind die $Z^{(i)}$ die verschiedenen Skalar-Zernike-Funktionen und die $b^{(i)}$ die zugehörigen Koeffizienten, die zur korrekten Beschreibung des gemessenen skalaren Bildfehlers V erforderlich sind. Die Koeffizienten $b^{(i)}$ werden mit Hilfe gängiger mathematischer Variationsmethoden so bestimmt, daß eine möglichst gute Anpassung der Linearkombination der Zernike-Funktionen an die Meßdaten des Gesamtabbildungsfehlers erfolgt. Die gefundenen Koeffizienten $b^{(i)}$ können als Koeffizientenspektrum S aufgefaßt werden. Das gefundene Koeffizientenspektrum S in der Ausgangsstellung 18 wird nachfolgend mit $S_0$ bezeichnet.

Prinzipiell lassen sich alle Abbildungsfehlertypen, die sich zum Gesamtabbildungsfehler überlagern, durch eine derartige Linearkombination beschreiben, sofern nur ausreichend hohe Ordnungen i der skalaren bzw. vektoriellen Zernike-Funktionen in die Linearkombinationen einbezogen werden. Beispiele für solche Abbildungsfehlertypen sind die Bildschale, die mit skalaren Feldern beschrieben werden kann, sowie der Astigmatismus, die Koma und die Verzeichnung, die mit vektoriellen Feldern beschrieben werden können.

Die gerade beschriebenen Verfahrensschritte (Meßschritt 19, Berechnungsschritt 20) werden in analoger Weise als Meßschritt 21 und Berechnungsschritt 22 bei einer neuen Position 23 der optischen Elemente 7, 8 des Projektionsobjektivs 6 durchgeführt. Die neue Position 23 ist ebenfalls in Figur 2 schematisch dargestellt. Hier ist das optische Element 7 gegenüber dem optischen Element 8 um einen Drehwinkel $\alpha_1$ derart verdreht, daß die Umfangsmarkierung 10' gegenüber der in der Ausgangsposition 18 fluchtenden Postition in Figur 2 nach rechts gerückt ist.

Die Zuordnung der Positionen 18 bzw. 23 des Projektionsobjektivs 6 zu den Verfahrensschritten 19, 20 bzw. 21, 22 ist in Fig. 2 durch strichpunktierte Linien angedeutet.

Für die neue Position 23 ergibt sich als Ergebnis des Berechnungsschritts 22 ein Koeffizientenspektrum $S_1$,

welches die Linearkombination der Zernike-Funktionen zur Beschreibung des Gesamtabbildungsfehlers in der neuen Position 23 repräsentiert.

Wenn nach dem Berechnungsschritt 22 die Linearkombinationen der Zernike-Funktionen zur Angabe der Gesamtabbildungsfehler des Projektionsobjektivs 6 in der Ausgangsposition 18 und der neuen Position 23 vorliegen, erfolgt in einem Analyseschritt 24 die Berechnung der einzelnen Abbildungsfehler der optischen Elemente 7 und 8.

Hierzu wird ausgenutzt, daß sich aufgrund der Orthogonalität der Zernike-Funktionen folgende Beziehungen aufstellen lassen:

$$S_0 = S_{OE1} + S_{OE2}$$

sowie:

$$S_1 = T(\alpha_1) \, S_{OE1} + S_{OE2}$$

Hierbei stehen $S_{OE1}$ und $S_{OE2}$ für die Koeffizientenspektren, die die einzelnen Abbildungsfehler der optischen Elemente 7 (Element eins, E1) und 8 (Element zwei, E2) beschreiben. $T(\alpha_1)$ bezeichnet die Drehmatrix, die aufgrund der Verdrehung des optischen Elements 7 um den Drehwinkel $\alpha_1$ auf dessen Koeffizientenspektrum $S_{OE1}$ anzuwenden ist, um in den stationären Raumkoordinaten das Koeffizientenspektrum des gedrehten optischen Elements 7 zu beschreiben.

Aus den beiden letzten oben angegebenen Gleichungen lassen sich direkt die Koeffizientenspektren der optischen Elemente 7 und 8 berechnen:

$$S_{OE1} = [T(\alpha_1) - E]^{-1} (S_1 - S_0)$$

$$S_{OE2} = S_0 - S_{OE1}$$

Hierbei steht E für die Einheitsmatrix. Durch Einsetzen der ermittelten Koeffizientenspektren in die Linearkombination der Zernike-Funktionen ergeben sich die Abbildungsfehler der einzelnen optischen Elemente 7, 8.

In einem an den Analyseschritt 24 anschließenden Berechnungsschritt 25 wird eine Zielposition des optischen Elements 7 berechnet, in welcher der Gesamtabbildungsfehler des Projektionsobjektivs 6 optimiert ist.

Hierbei wird in Abhängigkeit vom Drehwinkel $\alpha$ des optischen Elements 7 das Gesamt-Koeffizientenspektrum

$$S_{Ges} = T(\alpha) \, S_{OE1} + S_{OE2}$$

gesucht, für das der RMS-Wert des Gesamtabbildungsfehlers oder alternativ der maximale Betrag des Gesamtabbildungsfehlers im Feld minimiert sind. Als Optimierungsgröße kommt auch eine Kombination des RMS-Werts und des maximalen Betrags des Gesamtabbildungsfehlers in Frage.

Allgemein kann zur Bestimmung eines Parameters (hier des Drehwinkels $\alpha$), für den ein Koeffizientenspektrum mit optimiertem Gesamtabbildungsfehler resultiert, jede Funktion eingesetzt werden, die das diesem Parameter entsprechende Koeffizientenspektrum enthält und die Qualität der Abbildung repräsentiert. Eine derartige Funktion wird nachfolgend Meritfunktion genannt. Das Ergebnis der Meritfunktion ist in der Regel ein Skalar, der zur Optimierung minimiert wird.

Das Gesamt-Koeffizientenspektrum wird durch Änderung des Drehwinkels $\alpha$ mittels bekannter mathematischer Methoden so lange variiert, bis ein Ziel-Drehwinkel $\alpha_Z$ gefunden ist, für den das Gesamt-Koeffizientenspektrum $S_{Ges}$ mit optimiertem Gesamtabbildungsfehler resultiert.

Der im Rechner 14 berechnete Ziel-Drehwinkel $\alpha_Z$ wird dann ausgegeben.

In einem abschließenden Steuer- bzw. Bewegungsschritt 26 wird das optische Element 7 gegenüber dem optischen Element 8 manuell um den Ziel-Drehwinkel $\alpha_Z$ verdreht. Der Gesamtabbildungsfehler des Projektionsobjektivs 6 ist dann optimiert.

Nachfolgend werden weitere Varianten von Projektionsbelichtungsanlagen bzw. Projektionsobjektiven und von Verfahren zu deren Optimierung beschrieben. Komponenten bzw. Verfahrensschritte, die solchen entsprechen, die oben schon erläutert wurden, tragen um jeweils 100 erhöhte Bezugszeichen und werden nicht nochmals im einzelnen diskutiert.

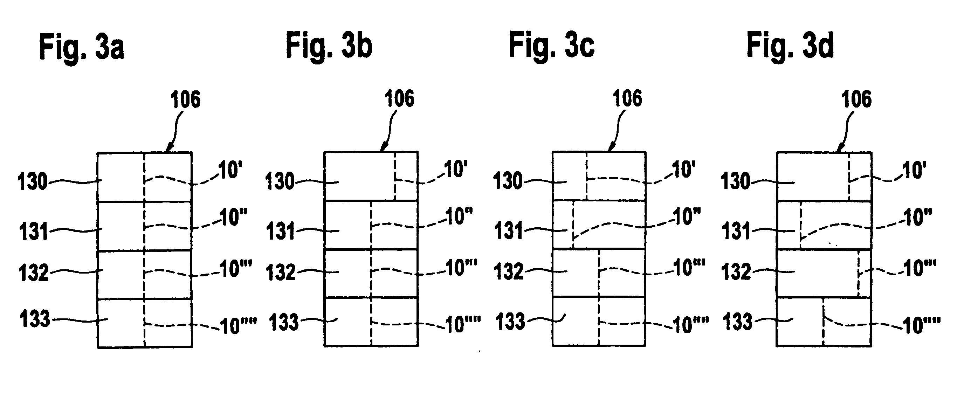

Ein alternatives Projektionsobjektiv 106 (vgl. Fig. 3) weist insgesamt drei um seine optische Achse verdrehbare optische Elemente 130, 131, 132 und ein stationäres optisches Element 133 auf. Die optischen Elemente 130 bis 133 tragen analog zum ersten beschriebenen Ausführungsbeispiel Umfangsmarkierungen 10' bis 10''''.

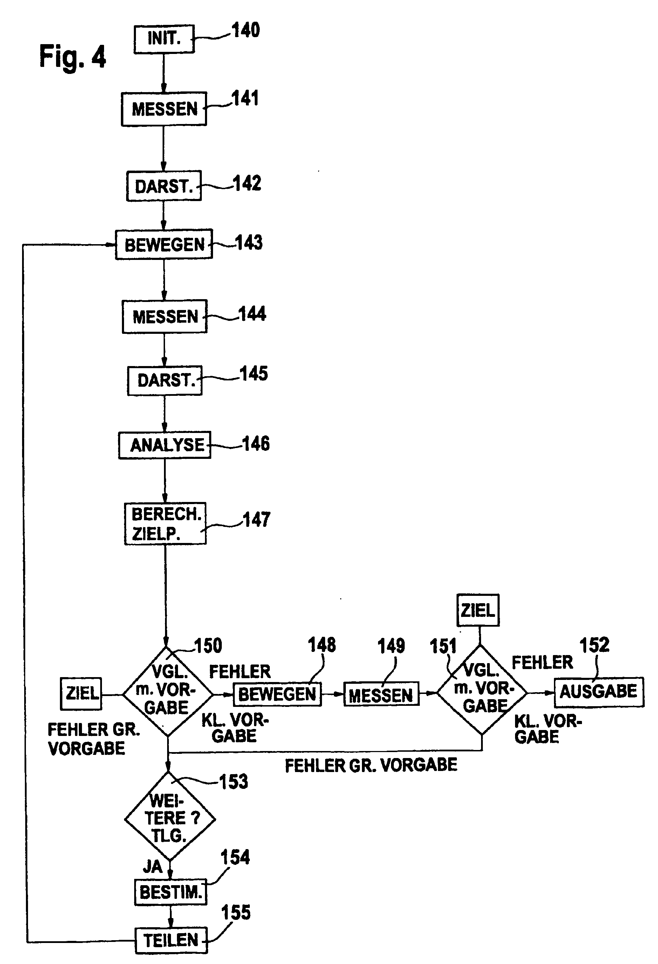

Ein Verfahren zur Optimierung des Gesamtabbildungsfehlers des Projektionsobjektivs 106 wird nachfolgend anhand der Figur 4 beschrieben:

In einem Initialisierungsschritt 140 erfolgt hierbei zunächst die Vorgabe, welcher Teil des Projektionsobjektivs 106 zuerst bewegt werden soll. Das Projektionsobjektiv 106 wird hierzu in einen ersten, einheitlich zu bewegenden Teil und einen zweiten stationären Teil unterteilt. Hierzu kann mittels einer von einem Zufallsgenerator erzeugten Zufallsfunktion eine einzelne Antriebseinrichtung 134, 135, 136 oder eine Kombination von diesen vorgegeben werden. Die im Initialisierungsschritt 140 bestimmte Unterteilung wird in ein Ausgabesignal umgesetzt, welches dem Benutzer im weiteren Verfahren ermöglicht, die optischen Elemente 130 bis 132 des Projektionsobjektivs 106 gemäß der im Initialisierungsschritt 140 bestimmten Unterteilung zu bewegen.

Welcher Teil des Projektionsobjektivs 106 zunächst bewegt wird, ist für das weitere Verfahren nicht von Bedeutung; diese Auswahl kann daher auch fest vorgegeben sein (z. B. zunächst Verdrehung des in Figur 3 obersten optischen Elements 130).

In einem Meßschritt 141 wird mit einer Luftbildmeßeinrichtung (vgl. Luftbildmeßeinrichtung 12 der Ausführung gem. Fig. 1) der Gesamtabbildungsfehler aller optischen Elemente in der Ausgangsposition des Projektionsobjektivs 106 gemessen. Dies erfolgt in analoger Weise, wie dies im Zusammenhang mit den Figuren 1 und 2 (Meßschritte 19 bzw. 21) beschrieben wurde.

In einem Berechnungsschritt 142 wird ein Koeffizientenspektrum $S_0$ anhand des im Meßschritt 141 gemessenen Bildfehlers ermittelt. Dies geschieht analog wie im Zusammenhang mit dem Optimierungsverfahren nach Figur 2 (Berechnungsschritt 20 bzw. 22) beschrieben.

In einem Bewegungsschritt 143 erfolgt anschließend die Verdrehung des im Initialisierungsschritt 140 vorgegebenen zu bewegenden Teils um einen Drewinkel $\alpha_1$. Die optischen Elemente 130 bis 133 des Projektionsobjektivs 106 befinden sich dann in einer neuen Meßposition.

In einem weiteren Meßschritt 144 wird der Gesamtabbildungsfehler des Projektionsobjektivs 106 in der neuen Meßposition erneut gemessen.

Auch der im Meßschritt 144 bestimmte Bildfehler wird in einem nachfolgenden Berechnungsschritt 145 in ein Koeffizientenspektrum $S_1$ umgesetzt.

In einem Analyseschritt 146 erfolgt anschließend eine Berechnung der Abbildungsfehler des bewegten Teils und des stationären Teils des Projektionsobjektivs 106.

Dies erfolgt in analoger Weise, wie bereits im Zusammenhang mit der Figur 2 (Analyseschritt 24) beschrieben. Der bewegte Teil des Projektionsobjektivs 106 entspricht dabei dem optischen Element 7 in Figur 2 und der stationäre Teil des Projektionsobjektivs 106 dem optischen Element 8. Statt den Koeffizientenspektren $S_{OE1}$ und $S_{OE2}$ der optischen Elemente 7 und 8 beim Verfahren nach Figur 2 ergeben sich beim Verfahren nach Figur 4 Koeffizientenspektren $S_{BT}$ für den bewegten Teil sowie $S_{ST}$ für den stationären Teil des Projektionsobjektivs 106.

In analoger Weise wie beim Berechnungsschritt 25 des Verfahrens nach Figur 2 wird in einem Berechnungsschritt 147 mit Hilfe einer Meritfunktion ein Ziel-Drehwinkel $\alpha_Z$ berechnet, um den der bewegte Teil des Projektionsobjektivs 106 zu verdrehen ist, damit der Bildfehler des Projektionsobjektivs 106 gemäß der Meritfunktion minimiert ist. Ergebnis des Berechnungsschritts 147 ist eine Zielposition des Projektionsobjektivs 106 sowie das Gesamtkoeffizientenspektrum des berechneten Gesamtabbildungsfehlers in der Zielposition. Die Zielposition wird zu diesem Zeitpunkt noch nicht real eingestellt sondern liegt als fiktives Berechnungsergebnis vor.

Bis auf den anfänglichen Initialisierungsschritt 140 entsprechen also die Verfahrensschritte 141 bis 147 des Optimierungsverfahrens nach Figur 4 den Verfahrensschritten 19 bis 22 sowie 24 und 25 des Optimierungsverfahrens nach Figur 2. Zusätzlich ist beim Verfahren nach Figur 4 noch der Bewegungsschritt 143 explizit angegeben, der beim Verfahren nach Figur 2 dem Unterschied zwischen der Ausgangsposition 18 und der neuen Meßposition 23 entspricht.

In einem Vergleichsschritt 150 wird der im Berechnungsschritt 147 berechnete Gesamtabbildungsfehler mit einem Vorgabewert (Ziel) verglichen, der in einem Speicher abgelegt ist.

Wenn der Vergleichsschritt 150 ergibt, daß der Gesamtabbildungsfehler kleiner ist als der Vorgabewert, erfolgt in einem Bewegungsschritt 148 eine entsprechende Bewegung, so daß der bewegte Teil des Projektionsobjektivs 106 in die Zielposition gebracht wird.

In der im Bewegungsschritt 148 eingestellten Zielposition des Projektionsobjektivs 106 wird erneut mit dem Wellenfrontsensor der Gesamtabbildungsfehler des Projektionsobjektivs 106 gemessen. Dies erfolgt in einem Meßschritt 149.

In einem weiteren Vergleichsschritt 151 wird der im Meßschritt 149 gemessene Gesamtabbildungsfehler mit dem Vorgabewert (Ziel) verglichen. Durch diese Meßwertprüfung wird sichergestellt, daß auch tatsächlich die Zielvorgabe eingehalten wird. Abweichungen zwischen dem berechneten und dem gemessenen Gesamtabbildungsfehler können sich z. B. durch Einflußgrößen ergeben, die bei der Berechnung des Gesamtabbildungsfehlers nur genähert oder gar nicht berücksichtigt wurden.

Wenn der Vergleichsschritt 151 ergibt, daß auch der gemessene Gesamtabbildungsfehler kleiner ist als der Vorgabewert, wird der im Meßschritt 149 gemessene Gesamtabbildungsfehler nach dem Vergleichsschritt 151 in einem Ausgabeschritt 152 ausgegeben. Das Optimierungsverfahren ist in diesem Fall beendet.

Ergibt der Vergleich im Vergleichsschritt 150 oder im Vergleichsschritt 151, daß der im Berechnungsschritt 147 berechnete oder der im Meßschritt 149 ermittelte Gesamtabbildungsfehler größer ist als der Vorgabewert, wird in einem weiteren Vergleichsschritt 153 bestimmt, ob noch Teile des Projektionsobjektivs 106 vorliegen, die noch in relativ noch nicht zueinander bewegte Teile unterteilt werden können. Dieser Vergleich erfolgt, indem die bisherige Bewegung der optischen Elemente 130 bis 132 des Projektionsobjektivs 106, die im Bewegungsschritt 143 initiiert wurde, mit den prinzipiellen Bewegungsmöglichkeiten der optischen Elemente 130 bis 132 des Projektionsobjektivs 106 verglichen wird. Dies geschieht durch Auswertung entsprechender Bewegungsdaten, die durch den Benutzer im Zuge der bis dahin erfolgten manuellen Verdrehung der Elemente 130 bis 132 in ein nicht dargestelltes Eingabeterminal des Rechners 14 eingegeben und als Vergleichswerte herangezogen werden.

Das vier gegeneinander bewegliche optische Elemente 130-133 umfassende Projektionsobjektiv 106 läßt sich nach einer ersten Bewegung eines beweglichen Teils gegenüber einem stationären Teil natürlich noch in weitere gegeneinander bewegliche Teile zerlegen (vgl. hierzu Fig. 3). Wird beispielsweise beim Bewegungsschritt 143 das optische Element 130 allein verdreht, liegt noch ein stationärer Teil des Projektionsobjektivs 106 mit den optischen Elementen 130 bis 133 vor. Dieser Teil läßt sich z. B. unterteilen in einen beweglichen Teil mit dem optischen Element 131, der gegenüber einem stationären Teil mit den optischen Elementen 132, 133 bewegt wird.

Nach einem nur einmal durchlaufenen Bewegungsschritt 143 liegen daher beim Projektionsobjektiv 106 noch mehrere mögliche weitere Unterteilungsmöglichkeiten in einen nächsten zu bewegenden Teil und in einen nächsten stationären Teil vor.

Dieses Ergebnis des Vergleichsschritts 153 führt daher zu einem Bestimmungsschritt 154, bei dem anhand der früheren Drehvorgänge bestimmt wird, ob es mehrere Möglichkeiten gibt, die bereits gegeneinander verdrehten Teile des Projektionsobjektivs 1 weiter in gegeneinander zu verdrehende Teile zu unterteilen. Dies ist z. B. dann der Fall, wenn beim ersten Bewegungsschritt 143 die optischen Elemente 130, 131 gegenüber den stationär verbleibenden optischen Elementen 132, 133 gemeinsam um einen Drehwinkel $\alpha$ verdreht werden. In diesem Fall liegt ein bewegter Teil des Projektionsobjektivs 106 vor, der die optischen Elemente 130, 131 umfaßt und somit nochmals unterteilt werden kann, da die optischen Elemente 130, 131 ihrerseits gegeneinander beweglich sind. Außerdem liegt der zunächst stationäre Teil mit den optischen Elementen 132, 133 vor, der ebenfalls nochmals unterteilbar ist, da das optische Element 132 gegen das optische Element 133 verdrehbar ist.

In einem solchen Fall mit mehreren Möglichkeiten der weiteren Unterteilung wird anhand des Ergebnisses des Analyseschritts 146 im Bestimmungsschritt 154 derjenige noch unterteilbare Teil bestimmt, dessen Abbildungsfehler den größten Beitrag zum Gesamtabbildungsfehler, der im Meßschritt 149 bestimmt wurde, liefert.

In einem Unterteilungsschritt 155 wird die im Bestimmungsschritt 154 bestimmte Unterteilung in ein Ausgabesignal umgesetzt. Dieses ermöglicht dem Benutzer im weiteren Verfahren, die optischen Elemente 130 bis 132 des Projektionsobjektivs 106 gemäß der im Bestimmungsschritt 154 bestimmten Unterteilung zu bewegen.

Das Verfahren wird daher beim Bewegungsschritt 143 wieder aufgenommen. In der Folge werden die Verfahrensschritte 143 bis 147, 150, wie oben beschrieben, erneut durchlaufen, wobei beim Bewegungsschritt 143 die Bewegung des zu bewegenden Teils des Projektionsobjektivs 106 gemäß der im Bestimmungsschritt 154 vorgegebenen und im Unterteilungsschritt 155 umgesetzten Unterteilung erfolgt.

Das Berechnen der Zielposition des Projektionsobjektivs 106 (Berechnungsschritt 147) ist beim zweiten Durchlauf des Verfahrens nicht mehr nur auf die Bestimmung eines Ziel-Drehwinkels, sondern auf die Bestimmung zweier Ziel-Drehwinkel gerichtet, da bei diesem zweiten Durchlauf schon insgesamt drei gegeneinander bewegte Teile innerhalb des Projektionsobjektivs 106 vorliegen, deren Positionen über zwei Drehwinkel eindeutig definiert sind.

Grundsätzlich ist es bei einer alternativen Variante des Optimierungsverfahrens möglich, den Vergleichsschritt 150 auszulassen und nach jeder Analyse im Analyseschritt 146 und nachfolgenden Berechnung der Zielposition im Berechnungsschritt 147 eine reale Verdrehung des Projektionsobjektivs 106 in die zuletzt berechnete Zielposition und eine Messung des in dieser Positionskonfiguration vorliegenden Gesamtabbildungsfehlers vorzunehmen. Ein derartiges Verfahren ist jedoch in der Regel aufwendiger als die oben beschriebene Variante, in der ein Bewegen des Projektionsobjektivs in die Zielposition erst dann erfolgt, wenn der berechnete Gesamtabbildungsfehler kleiner ist als der Vorgabewert.

Eine Möglichkeit zur Bestimmung der Zielposition gemäß dem Berechnungsschritt 147 basiert auf Prinzipien der statistischen Mechanik. Dieses Berechnungsverfahren stützt sich auf die Beobachtung, daß ein physikalisches Vielteilchensystem im thermischen Gleichgewicht ein Minimum der freien Energie einnimmt. Die Suche nach dem globalen Minimum einer Meritfunktion (nachfolgend abgekürzt MF), welche von einer Mehrzahl von Parametern, d. h. den Drehwinkeln der verschiedenen möglichen Drehungen der zueinander beweglichen optischen Elemente 130 bis 133 zueinander, abhängt, wird analog zur Suche nach dem globalen Minimum der freien Energie eines Vielteilchensystems behandelt. Beispiele weiterer möglicher Berechnungsverfahren sind bekannte genetische Algorithmen und Evolutionsstrategien. Diese Berechnungsverfahren sind dem Fachmann bekannt und sind z.B. in folgenden Veröffentlichungen beschrieben: Press, Teukolsky, Vetterling, Flannery, "Numerical Recipes in C - The art of scientific computing", second edition, Cambridge University Press, 1992; E.L. Lawler et al. (Hrsg.), "The traveling salesman problem. A guided tour of combinatorial optimization", Wiley Chichester 1985; M. Jünger, G. Reinelt, G. Rinaldini, "The traveling salesman problem" in "Annotated bibliographies in combinatorial optimization", Mauro Dell'Amico (Hrsg.), Wiley Chichester, 199, 1997; D. Applegate et al., "On the solution of traveling salesman problems" in Documenta Mathematica, Extra Volume, Proceedings of the ICM 98, 645, 1998; R.E. Burkard, "Well solvable special cases of the traveling salesman problem: A survey" in SIAM Review, Vol. 40, 496, 1998; Tagungsberichte zu "The Seventh International Conference on Genetic Algorithms", July 19-23, 1997, Michigan State University, East Lansing, Michigan.

Die Bestimmung der Zielposition wird durchgeführt, indem bestimmte Positionskonfigurationen des Projektionsobjektivs fiktiv, d.h. ohne daß diese Positionskonfigurationen tatsächlich real angefahren werden, vorgegeben werden und die diesen Positionskonfigurationen jeweils zugehörige Meritfunktion ausgewertet wird. Diese Auswertung ist, wie oben erläutert, möglich, da die Einzelbeiträge der gegeneinander fiktiv verdrehten optischen Elemente des Projektionsobjektivs bekannt sind. Abhängig von der Berechnung wird entschieden, ob eine neue Positionskonfiguration, die durch Fiktivdrehung mindestens eines optischen Elements um mindestens einen vorgegebenen Drehwinkel erreicht wurde, als neue bessere Positionskonfiguration, mit der die Berechnung fortgesetzt wird, akzeptiert wird, oder ob die Berechnung mit der alten Positionskonfiguration fortgeführt wird.

Das Verfahren zur Berechnung einer Zielposition des oder der bewegten Teile des Projektionsobjektivs 106 erlaubt ein rasches Auffinden einer Zielposition, ohne daß dabei alle möglichen Positionsvarianten des oder der bewegten Teile angefahren werden müssen. Das Berechnungsverfahren kann so ausgelegt werden, daß es die Gewähr bietet, daß ein schon erreichtes Minimum des Gesamtabbildungsfehlers wieder verlassen wird und daß Nebenminima, d. h. Positionsbereiche, in denen der Gesamtabbildungsfehler verringert ist, jedoch noch von einem globalen Minimum entfernt ist, auch wieder verlassen werden können.

Alternativ zu den vorstehend diskutierten statistischen Berechnungsverfahren ist es zur Bestimmung einer Zielposition natürlich möglich, alle möglichen Positionskonfigurationen, die das Projektionsobjektiv 106 einnehmen kann, gezielt rechnerisch zu untersuchen, um auf diese Weise die optimale Positionskonfiguration des oder der bewegten Teile des Projektionsobjektivs 106 zu ermitteln. Ein derartiges Vorgeben aller möglichen Positionskombinationen des oder der bewegten Teile des Projektionsobjektivs 106 eignet sich dann, wenn die Anzahl des oder der bewegten Teile noch gering ist.

Eine mögliche Sequenz von Unterteilungen des Projektionsobjektivs 106 nach dem Verfahren von Figur 4 zeigt Figur 3. In Fig. 3a befinden sich die optischen Elemente 130 bis 133 des Projektionsobjektivs 106 in der Ausgangsposition. Hier fluchten alle Umfangsmarkierungen 10' bis 10''''.

Im Initialisierungsschritt 140 wird das Projektionsobjektiv 106 in einen ersten zu bewegenden Teil, nämlich das optische Element 130, und in einen zweiten stationären Teil, nämlich die optischen Elemente 131 bis 133 unterteilt. Für das optische Element 130 ergibt sich dann nach Durchlaufen der Verfahrensschritte 141 bis 147 von Fig. 4 die berechnete Zielposition, die in Figur 3b gezeigt ist. Die Umfangsmarkierung 10' des optischen Elements 130 ist dabei in Figur 3b ein Stück weit nach rechts gerückt.

Diese Zielposition wird nicht real angefahren. Vielmehr werden im Rahmen des Verfahrens nach Fig. 4 erst die Vergleichsschritte 150 und ggf. 151 durchgeführt. Im Rahmen der Beschreibung der Fig. 3 wird davon ausgegangen, daß sich bei diesen Vergleichsschritten zu den Figuren 3a bis 3c ergeben hat, daß der Gesamtabbildungsfehler in der Zielposition größer ist als der Vorgabewert.

Im daher erforderlichen anschließenden Unterteilungsschritt 155 wird der noch unterteilbare Teil des Projektionsobjektivs 106, nämlich die bislang noch nicht relativ zueinander bewegten optischen Elemente 131 bis 133, wiederum in einen ersten zu bewegenden Teil, nämlich das optische Element 131 und in einen zweiten stationären Teil, nämlich die optischen Elemente 132, 133, unterteilt.

Nach Durchlaufen der Verfahrensschritte 143 bis 147 ergibt sich für die optischen Elemente des Projektionsobjektivs 106 eine neue berechnete Zielposition, die in Figur 3c dargestellt ist. Hier sind die optischen Elemente 130 und 131 aus der in Figur 3a gezeigten Ausgangsposition herausgedreht. Das optische Element 130 hat in der neuen Zielposition (vgl. Fig. 3c) eine andere Position inne als in der Ausgangsposition (vgl. Fig. 3a) und in der Positionskonfiguration, bei der das optische Element 130 alleine zur Verdrehung optimiert wurde (vgl. Fig. 3b). Dies ergibt sich aufgrund des in Fig. 3c neu hinzugekommenen Freiheitsgrades, nämlich der Verdrehbarkeit des optischen Elements 131.

Im Anschluß an den zum zweiten Mal durchlaufenen Unterteilungsschritt 155 wird der noch verbleibende unterteilbare Teil des Projektionsobjektivs 106, nämlich die optischen Elemente 132 und 133 (vgl. Figur 3c), in einen ersten zu bewegenden Teil, nämlich das optische Element 132, und einen zweiten stationären Teil, nämlich das optische Element 133 aufgeteilt. Anschließend werden wiederum die Verfahrensschritte 143 bis 147 durchlaufen. Es ergibt sich eine berechnete Zielposition, die in Figur 3d dargestellt ist. Analog zu dem in Zusammenhang mit Figur 3c Ausgeführten gilt auch hier, daß die Positionen der optischen Elemente 130, 131 nicht mit ihrer früheren Positionen (vgl. Figur 3c) übereinstimmen müssen. Dies kann sich jedoch zufällig ergeben, wie in Figur 3 dargestellt.

Bei der Berechnung der Zielposition der Figur 3d liegen drei unabhängig voneinander verdrehbare optische Elemente 130, 131, 132 vor. Wenn jedes dieser optischen Elemente 130 bis 132 mit einer Positionsschrittweite von $1°$ eingestellt werden kann, gibt es für jedes der optischen Elemente 130 bis 132 360 mögliche Positionen; insgesamt liegen $360^4$, d. h. mehr als $1,6 \times 10^{10}$ mögliche Positionskombinationen für das Projektionsobjektiv 106 vor. Dies verdeutlicht, daß es schon bei vier gegeneinander beweglichen optischen Elementen und einer Positionsschrittweite von $1°$ nicht mehr möglich ist, alle möglichen Positionskombinationen zum Auffinden des globalen Optimums physisch oder rechnerisch anzusteuern. In diesem Fall führt eines der oben diskutierten statistischen Verfahren wesentlich schneller zu einer Zielposition, in der der Gesamtabbildungsfehler im Rahmen der durch die zugelassenen Bewegungsfreiheitsgrade möglichen Stellungen bis auf einen Wert in der Nähe des Optimalwerts reduziert ist.

Beim Verfahren nach Figur 4 erfolgt eine Unterteilung des Projektionsobjektivs 106 in einen oder mehrere zu bewegende Teile und einen stationären Teil so lange, bis ein vorgegebener Gesamtabbildungsfehler unterschritten wird. Alternativ ist es auch möglich, in jedem Fall, also ohne Vergleich mit einem Vorgabewert eines Gesamtabbildungsfehlers, alle möglichen Unterteilungen des Projektionsobjektivs 106 durchzuführen. In diesem Fall wird der Vergleichsschritt 150 übersprungen. Das Verfahren endet dann, wenn eine vollständige Unterteilung des Projektionsobjektivs 106 in alle optischen Elemente 130 bis 133 erfolgt ist und für diese vollständige Unterteilung die Zielposition (Steuerschritt 148) erreicht wurde. In dieser Zielposition wird dann der für das gegebene System kleinste Wert des Gesamtabbildungsfehlers erreicht.

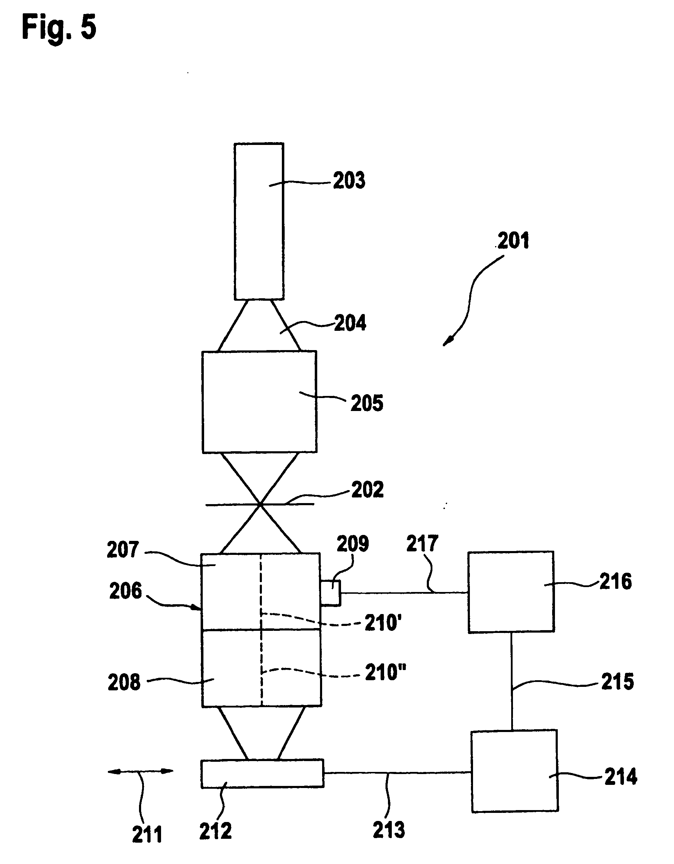

Bei einer in der Fig. 5 dargestellten alternativen Ausführung der Projektionsbelichtungsanlage, die mit 201 bezeichnet ist, erfolgt die Verdrehung des optischen Elements 207 durch einen Antrieb 209, z.B. durch einen Elektromotor.

Der den Gesamtabbildungsfehler des Projektionsobjektivs 206 auswertende Rechner 214 ist bei diesem Ausführungsbeispiel über eine Signalleitung 215 mit einer Steuereinrichtung 216 verbunden, die über eine Steuerleitung 217 den Antrieb 209 ansteuert. Bei diesem Ausführungsbeispiel bilden der Antrieb 209, die Luftbildmeßeinrichtung 212, der Rechner 214 und die Steuereinrichtung 216 gemeinsam eine Optimierungseinrichtung zur Optimierung der Abbildungseigenschaften des Projektionsobjektivs 206.

Das Verfahren nach Fig. 2 ist beim Projektionsobjektiv 201 entsprechend anwendbar. Beim abschließenden Bewegungsschritt 26 wird anstelle einer manuellen Verdrehung die Antriebseinrichtung 209 über die Steuereinrichtung 216 so angesteuert, daß das optische Element 207 gegenüber dem optischen Element 208 um den Ziel-Drehwinkel $\alpha_Z$ verdreht ist.

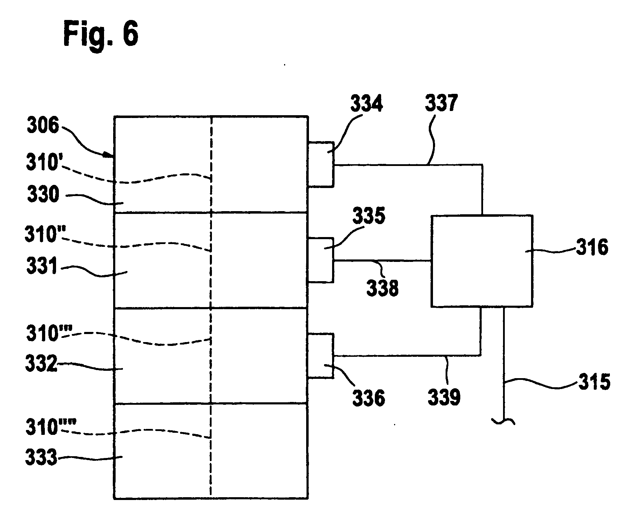

Bei einer in Fig. 6 dargestellten weiteren Variante eines Projektionsobjektivs, die insgesamt mit 306 bezeichnet ist, sind die in Figur 6 obersten drei optischen Elemente 330 bis 332 mittels Antriebseinrichtungen 334, 335 und 336 um die optische Achse des Projektionsobjektivs 306 verdrehbar. Dazu sind die Antriebseinrichtungen 334 bis 336 über Steuerleitungen 337, 338 und 339 mit einer Steuereinrichtung 316 verbunden. Über eine Signalleitung 315 steht die Steuereinrichtung 316 mit einem in Fig. 6 nicht dargestellten Rechner (vgl. hierzu die Optimierungseinrichtung nach Fig. 5) in Verbindung.

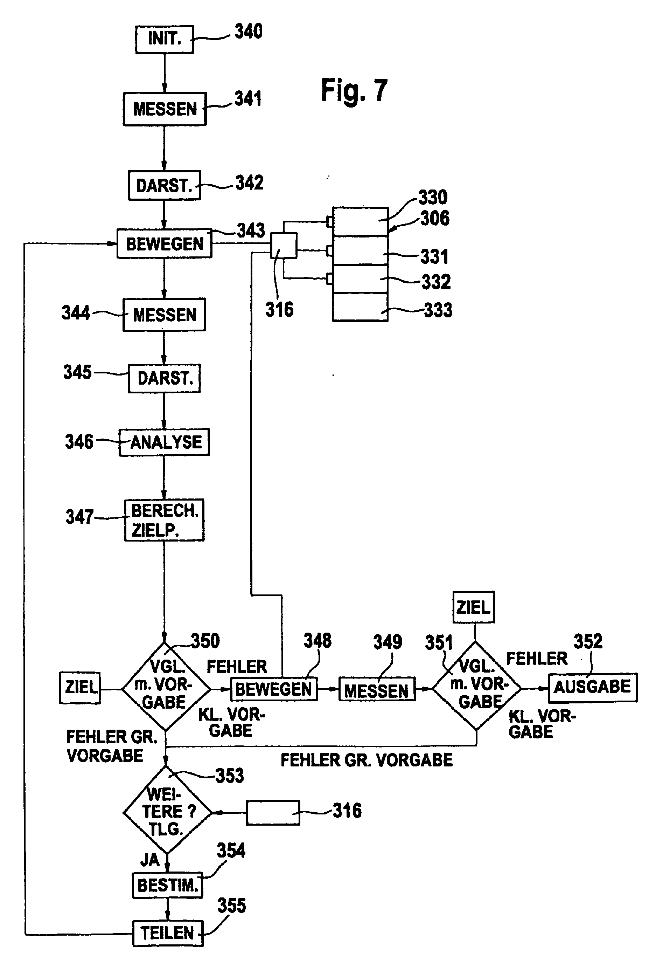

Beim Projektionsobjektiv nach Fig. 6 ist das Optimierungsverfahren nach Fig. 4 entsprechend anwendbar. Dieses entsprechende Verfahren ist in Fig. 7 dargestellt und wird nachstehend nur dort beschrieben, wo es sich vom Verfahren nach Fig. 7 unterscheidet. Die beim Verfahren nach Fig. 7 im Initialisierungsschritt 340 bestimmte Unterteilung wird hierzu in ein Datensignal umgesetzt, welches der Steuereinrichtung 316 im weiteren Verfahren ermöglicht, im Bewegungsschritt 343 die optischen Elemente 330 bis 332 des Projektionsobjektivs 306 gemäß der im Initialisierungsschritt 340 bestimmten Unterteilung zu bewegen.

Im Bewegungsschritt 348 erfolgt anstelle einer manuellen Verdrehung eine entsprechende Ansteuerung der Steuereinrichtung 316, so daß der bewegte Teil des Projektionsobjektivs 306 in die Zielposition gebracht wird.

Der Vergleichsschritt 353 kann bei der Projektionsbelichtungsanlage mit dem Projektionsobjektiv 306 durch Auslesen entsprechender, die Bewegungshistorie wiedergebender Bewegungsdaten erfolgen, welche in der Steuereinrichtung 316 abgelegt wurden. Die im Bestimmungsschritt 354 bestimmte Unterteilung wird entsprechend in ein Datensignal umgesetzt, welches der Steuereinrichtung 316 im weiteren Verfahren ermöglicht, im Bewegungsschritt 343 die optischen Elemente 330 bis 332 des Projektionsobjektivs 306 gemäß der im Bestimmungsschritt 354 bestimmten Unterteilung zu bewegen.

Vorstehend wurde die für die verschiedenen Varianten des Optimierungsverfahrens erforderliche Messung des Gesamtabbildungsfehlers anhand einer Luftbildmessung, d. h. einer positionsaufgelösten Intensitätsmessung im Bereich der Bildebene oder einer hierzu konjugierten Ebene des Projektionsobjektivs, realisiert.

Eine Messung des Gesamtabbildungsfehlers kann alternativ auch durch ein bekanntes interferometrisches Verfahren erfolgen, welches Meßinformationen liefert, die im Idealfall eine exakte Rekonstruktion der Wellenfront erlauben.

Bei Luftbilddaten können Mehrdeutigkeiten auftreten, die eine durch die Zerlegung in Zernikefunktionen erfolgende eindeutige Zuordnung einzelner Beiträge zum Gesamtabbildungsfehler verhindern, da eine Bestimmung der radialen Ordnungen dieser Zerlegung nicht eindeutig möglich ist: So hat beispielsweise eine Zerlegung eines Abbildungsfehlers vom Typ "Koma" in Zernikefunktionen radiale Beiträge der Zernikefunktionen Z7 und Z14, wobei bei einer Luftbildmessung in der Regel nicht entschieden werden kann, ob eine gemessene radiale Abhängigkeit des Gesamtabbildungsfehlers durch den Beitrag der Zernikefunktion Z7 oder durch den Beitrag der Zernikefunktion Z14 verursacht wurde.

Anstelle des Erhebens von Wellenfrontdaten mittels Interferometrie können zur Beschreibung des radialen Verlaufs des Gesamtabbildungsfehlers ausreichende Wellenfrontinformationen auch aus Luftbildmessungen bei verschiedenen Beleuchtungsgeometrien, sog. Beleuchtungssettings, gewonnen werden. Dies ist mit einer Projektionsbelichtungsanlage möglich, die im Vergleich zu denen, die in den Figuren 1 und 5 dargestellt sind, nur geringfügig abgewandelt ist:

Hierzu wird im Bereich der Beleuchtungsoptik 5, 205 der Projektionsbelichtungsanlage 1, 201 eine Aperturblende mit veränderlicher Apertur eingebracht. Der Gesamtabbildungsfehler wird dann bei verschiedenen Formen der Apertur, z. B. bei verschiedenen Durchmessern des Beleuchtungsbündels 4, 204, vermessen. Aus diesen Messungen kann in einer für die vorstehenden Optimierungsverfahren ausreichenden Genauigkeit auf die verschiedenen radialen Wellenfrontordnungen und damit auch auf die verschiedenen radialen Ordnungen bei der Beschreibung des Gesamtabbildungsfehlers zurückgeschlossen werden.

Als Koeffizienten b, die das Koeffizientenspektrum S aufbauen, können auch bei dieser Zerlegung die Koeffizienten b zum Einsatz kommen, die sich unmittelbar aus der Anpassung einer Linearkombination aus Zernike-Funktionen an die mit dem Luftbildmeßeinrichtung gemessenen Bildfehlerdaten gewonnen werden. Diese Koeffizienten stellen jedoch entsprechend der vorstehenden Diskussion in der Regel ein Gemisch aus verschiedenen radialen Wellenfront-Ordnungen k dar, weshalb eine direkte Kenntnis einzelner radialer Ordnungen im allgemeinen nicht vorliegt. Sollen derartige radiale Wellenfront-Ordnungen k jedoch einzeln jeweils für sich optimiert werden, ist deren separate Kenntnis erforderlich. In diesem Fall wird statt des oben beschriebenen Koeffizientenspektrums S ein Koeffizientenspektrum verwendet, welches sich aus gewichteten Koeffizienten $\delta b$ zusammensetzt, die nach folgender Gleichung aus den Koeffizienten $b^l_i$, die zu verschiedenen (1 bis L) Beleuchtungssettings der Beleuchtungsoptik der Projektionsbelichtungsanlage gehören, gewonnen werden können:

$$\delta b_i(k) = \sum_{l=1}^{L} g^l(k) \, b_i^{\,l}$$

Die Differenzgewichte $g^l(k)$ werden hierbei derart gewählt, daß die Koeffizienten $\delta b$ direkt das Koeffizientenspektrum für eine radiale Wellenfront-Ordnung k wiedergeben.

**Patentansprüche**

1. Verfahren zur Optimierung der Abbildungseigenschaften
   von mindestens zwei optischen Elementen, bei dem mindestens eines der optischen Elemente relativ zu mindestens einem stationären optischen Element bewegt wird, mit folgenden Verfahrensschritten:

   a) Messen (19) des sich aus dem Abbildungsfehler des beweglichen optischen Elements (7; 207) und dem Abbildungsfehler des stationären optischen Elements (8; 208) zusammensetzenden Gesamtabbildungsfehlers aller optischen Elemente, wobei alle optischen Elemente von Meßlicht durchtreten werden;
   b) Darstellen (20) des gemessenen Gesamtabbildungsfehlers als Linearkombination der Basisfunktionen eines orthogonalen Funktionensatzes;
   c) Bewegen des beweglichen optischen Elements (7; 207) relativ zum stationären optischen Element (8; 208) in eine neue Meßposition (23);

d) Erneutes Messen (21) des sich aus dem Abbildungsfehler des beweglichen Elements (7; 207) und dem Abbildungsfehler des stationären optischen Elements (8; 208) zusammensetzenden neuen Gesamtabbildungsfehlers aller optischen Elemente, wobei alle optischen Elemente von Meßlicht durchtreten werden;

e) Darstellen (22) des neuen Gesamtabbildungsfehlers als Linearkombination der Basisfunktionen eines orthogonalen Funktionensatzes;

f) Berechnen (24) des Abbildungsfehlers des beweglichen optischen Elements (7; 207) und des Abbildungsfehlers des stationären optischen Elements (8; 208) unter Verwendung der in den Schritten b und e gewonnenen Darstellungen;

g) Berechnen (25) einer Zielposition des beweglichen optischen Elements (7; 207) aus dessen Abbildungsfehler und dem Abbildungsfehler des stationären optischen Elements (8; 208), in welcher der Gesamtabbildungsfehler minimiert ist;

h) Bewegen (26) des beweglichen optischen Elements (7; 207) in die Zielposition.

2. Verfahren nach Anspruch 1, wobei das mindestens eine bewegliche optische Element (7; 207; 130 bis 132; 330 bis 332) um die optische Achse verdrehbar ist.

3. Verfahren nach Anspruch 1 oder 2, wobei zur Messung des Gesamtabbildungsfehlers Luftbild-Daten herangezogen werden.

4. Verfahren nach einem der vorhergehenden Ansprüche, wobei zur Messung des Gesamtabbildungsfehlers die Wellenfrontdaten eines Abbildungsbündels (4; 204) nach dem Projektionsobjektiv (6; 106; 206; 306) gemessen werden.

5. Verfahren nach Anspruch 4 bei Rückbeziehung auf Anspruch 3, wobei die Luftbild-Daten bei verschiedenen Beleuchtungssettings gemessen werden.

6. Verfahren nach einem der vorhergehenden Ansprüche, **dadurch gekennzeichnet, daß** als orthogonaler Funktionensatz Zernikefunktionen gewählt werden.

## Claims

1. Method for optimizing imaging properties of at least two optical elements, in which at least one of the optical elements is moved relative to at least one stationary optical element, comprising the following method steps:

a) Measuring (19) of the overall image defect of all optical elements, consisting of the image defect of the movable optical element (7; 207) and the image defect of the at least one stationary optical element (8; 208), in which all optical elements are traversed by measuring light;

b) Representing (20) of the measured overall image defect as a linear combination of the base functions of an orthogonal function set;

c) Moving of the movable optical element (7; 207) relative to stationary optical element (8; 208) to a new measurement position (23);

d) Renewed measuring (21) of the new overall image defect of all optical elements, consisting of the image defect of the movable element (7; 207) and the image defect of the stationary optical element (8; 208), in which all optical elements are traversed by measuring light;

e) Representing (22) of the new overall image defect as a linear combination of the base functions of an orthogonal function set;

f) Calculating (24) of the image defect of the movable optical element (7; 207) and of the image defect of the stationary optical element (8; 208), using the representations obtained in steps b and e;

g) Calculating (25) of a target position of the movable optical element (7; 207) from its image defect and from the image defect of the stationary optical element (8; 208), in which the overall image defect is minimized;

h) Moving (26) of the movable optical element (7; 207) to the target position.

2. Method according to claim 1, wherein the at least one movable optical element (7; 207; 130 to 132; 330 to 332) can be rotated about the optical axis.

3. Method according to claim 1 or 2, wherein air image data are used for the measurement of the overall image defect.

14

**4.** Method according to one of the preceding claims, wherein the wave front data of an image bundle (4; 204) after the projection objective (6; 106; 206; 306) are measured for the measurement of the overall image defect.

**5.** Method according to claim 4 if depending on claim 3, wherein the air image data are measured at different illumination settings.

**6.** Method according to one of the preceding claims, **characterised in that** Zernike functions are chosen as orthogonal function set.

## Revendications

**1.** Procédé d'optimisation des caractéristiques de formation d'image d'au moins deux éléments optiques, dans lequel au moins un des éléments optiques est déplacé par rapport à au moins un élément optique fixe, avec les étapes de procédé suivantes :

a) mesure (19) du défaut total de formation d'image de tous les éléments optiques, composé du défaut de formation d'image de l' élément optique mobile (7 ; 207) et du défaut de formation d'image de l'élément optique fixe (8 ; 208), tous les éléments optiques étant traversés par la lumière de mesure ;
b) représentation (20) du défaut total de formation d' image mesuré sous forme de combinaison linéaire des fonctions de base d' un ensemble de fonctions orthogonales ;
c) déplacement de l'élément optique mobile (7 ; 207) par rapport à l'élément optique fixe (8 ; 208) dans une nouvelle position de mesure (23) ;
d) nouvelle mesure (21) du nouveau défaut total de formation d'image de tous les éléments optiques, composé du défaut de formation d'image de l'élément mobile (7 ; 207) et du défaut de formation d'image de l' élément optique fixe (8 ; 208), tous les éléments optiques étant traversés par la lumière de mesure ;
e) représentation (22) du nouveau défaut total de formation d'image sous forme de combinaison linéaire des fonctions de base d'un ensemble de fonctions orthogonales ;
f) calcul (24) du défaut de formation d'images de l'élément optique mobile (7 ; 207) et du défaut de formation d'images de l'élément optique fixe (8 ; 208) en utilisant des représentations acquises aux étapes b et e ;
g) calcul (25) d'une position cible de l'élément optique mobile (7 ; 207) à partir du défaut de formation d'image de celui-ci et du défaut de formation d'image de l'élément optique fixe (8 ; 208), dans lequel le défaut total de formation d'image est minimisé ;
h) déplacement (26) de l'élément optique mobile (7 ; 207) dans la position cible.

**2.** Procédé selon la revendication 1, dans lequel l'au moins un élément optique mobile (7 ; 207 ; 130 à 132 ; 330 à 332) est rotatif autour de l'axe optique.

**3.** Procédé selon la revendication 1 ou 2, dans lequel des données de photographie aérienne sont utilisées pour mesurer le défaut total de formation d'image.

**4.** Procédé selon l'une quelconque des revendications précédentes, dans lequel les données de front d'onde d'un faisceau de formation d'image (4 ; 204) sont mesurées après l'objectif de projection (6 ; 106 ; 206 ; 306) pour mesurer le défaut total de formation d'image.

**5.** Procédé selon la revendication 4, en référence à la revendication 3, dans lequel les données de photographie aérienne sont mesurées avec différents réglages d'éclairage.

**6.** Procédé selon l'une quelconque des revendications précédentes, **caractérisé en ce que** des fonctions de Zernike sont sélectionnées comme ensemble de fonctions orthogonales.

**Fig. 1**

## Fig. 2

# Fig. 3a

# Fig. 3b

# Fig. 3c

# Fig. 3d

106

130 — 10'

131 — 10"

132 — 10'''

133 — 10''''

106

130 — 10'

131 — 10"

132 — 10'''

133 — 10''''

106

130 — 10'

131 — 10"

132 — 10'''

133 — 10''''

106

130 — 10'

131 — 10"

132 — 10'''

133 — 10''''

**Fig. 4**

INIT. —140

MESSEN —141

DARST. —142

BEWEGEN —143

MESSEN —144

DARST. —145

ANALYSE —146

BERECH.
ZIELP. —147

150

ZIEL

VGL.
m. VOR-
GABE

FEHLER GR.
VORGABE

FEHLER 148 149 151

BEWEGEN → MESSEN

KL. VOR-
GABE

ZIEL

VGL.
m. VOR-
GABE

FEHLER 152

AUSGABE

KL. VOR-
GABE

FEHLER GR. VORGABE

WEI-
TERE ?
TLG. —153

JA

BESTIM. —154

TEILEN —155

EP 1 296 191 B1

# Fig. 5

20

# Fig. 6

**Fig. 7**

**EP 1 296 191 B1**

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0992853 A

**In der Beschreibung aufgeführte Nicht-Patentliteratur**

- **PRESS ; TEUKOLSKY ; VETTERLING ; FLANNERY.** Numerical Recipes in C - The art of scientific computing. Cambridge University Press, 1992
- The traveling salesman problem. A guided tour of combinatorial optimization. Wiley, 1985
- The traveling salesman problem. **M. JÜNGER ; G. REINELT ; G. RINALDINI.** Annotated bibliographies in combinatorial optimization. Wiley, 1997, vol. 199
- **D. APPLEGATE et al.** On the solution of traveling salesman problems. *Documenta Mathematica, Extra Volume, Proceedings of the ICM 98,* 1998, vol. 645
- **R.E. BURKARD.** Well solvable special cases of the traveling salesman problem: A survey. *SIAM Review,* 1998, vol. 40, 496
- **TAGUNGSBERICHTE.** *The Seventh International Conference on Genetic Algorithms,* 19. Juli 1997